(19) Europäisches Patentamt
European Patent Office
Office européen des brevets

(11) EP 1 361 583 A1

(12) DEMANDE DE BREVET EUROPEEN

(43) Date de publication:
12.11.2003 Bulletin 2003/46

(51) Int Cl.⁷: **G11C 17/18**

(21) Numéro de dépôt: 03007639.2

(22) Date de dépôt: 03.04.2003

(84) Etats contractants désignés:
AT BE BG CH CY CZ DE DK EE ES FI FR GB GR
HU IE IT LI LU MC NL PT SE SI SK TR
Etats d'extension désignés:
AL LT LV MK RO

(30) Priorité: 04.04.2002 FR 0204184

(71) Demandeur: STMicroelectronics S.A.
92120 Montrouge (FR)

(72) Inventeurs:
• Duval, Benjamin
83470 Saint Maximin (FR)
• Marinet, Fabrice
13790 Chateauneuf Le Rouge (FR)

(74) Mandataire: Marchand, André
OMNIPAT,
24 Place des Martyrs de la Résistance
13100 Aix-en-Provence (FR)

(54) **Procédé de programmation de cellules mémoire par claquage d'éléments antifusible**

(57) Procédé de programmation d'une rangée de cellules mémoire antifusible comprenant une étape de claquage d'au moins N éléments antifusible (AF1-AF$_N$) présents dans les cellules mémoire, le claquage d'un élément antifusible comprenant l'application d'une tension de claquage (Vhv) sur l'anode de l'élément antifusible, dans lequel les éléments antifusible sont claqués séquentiellement par groupes de P éléments antifusible avec P inférieur à N et au moins égal à 1, les éléments antifusible d'un même groupe recevant la tension de claquage simultanément, le claquage d'un groupe d'éléments antifusible suivant intervenant immédiatement après le claquage d'un groupe d'éléments antifusible précédent.

Fig. 3

## Description

La présente invention concerne un procédé de programmation d'une rangée de cellules mémoire antifusible, comprenant une étape de claquage d'au moins N éléments antifusible présents dans les cellules mémoire, le claquage d'un élément antifusible comprenant l'application d'une tension de claquage sur l'anode de l'élément antifusible.

L'utilisation de cellules mémoire antifusible dans les circuits intégrés permet de réaliser à moindre coût des zones mémoire non-volatiles ayant une capacité de stockage moyenne mais suffisante pour enregistrer des données permanentes de faible longueur comme un numéro de série de circuit intégré, un code secret, des données de paramétrage de grandeurs analogiques du circuit intégré, etc..

De façon générale, les mémoires de type fusible ou antifusible constituent une alternative avantageuse aux mémoires non-volatiles basées sur le principe de la rétention de charges électriques, utilisant par exemple des transistors à grille flottante.

Une cellule mémoire de type fusible comprend un élément fusible, par exemple un fusible en polysilicium, qui est initialement conducteur et devient non conducteur lorsqu'il est claqué, le claquage pouvant être fait au laser ou obtenu par application d'une tension de claquage.

Inversement, une cellule mémoire antifusible comprend un élément antifusible, généralement une couche d'oxyde, qui est initialement isolant et devient conducteur après être claqué, le claquage provoquant l'apparition d'un chemin conducteur dans l'oxyde.

Entre ces deux technologies, fusible ou antifusible, l'antifusible représente à l'heure actuelle la meilleure solution en termes de densité d'intégration et de flexibilité.

Les mémoires antifusible présentent toutefois un temps de programmation assez long, qui constitue un inconvénient majeur dans certaines applications, par exemple dans le cadre d'une production à grande échelle de circuits intégrés comprenant chacun une zone mémoire antifusible devant être programmée. Pour fixer les idées, le claquage collectif de 20 éléments antifusible nécessite l'application d'une tension de claquage pendant une durée de 50 ms environ. Cette durée n'est pas négligeable dans le domaine de la microélectronique, où les durées de programmation se chiffrent généralement en quelques dixièmes de milliseconde ou en quelques millisecondes plutôt qu'en plusieurs dizaines de millisecondes.

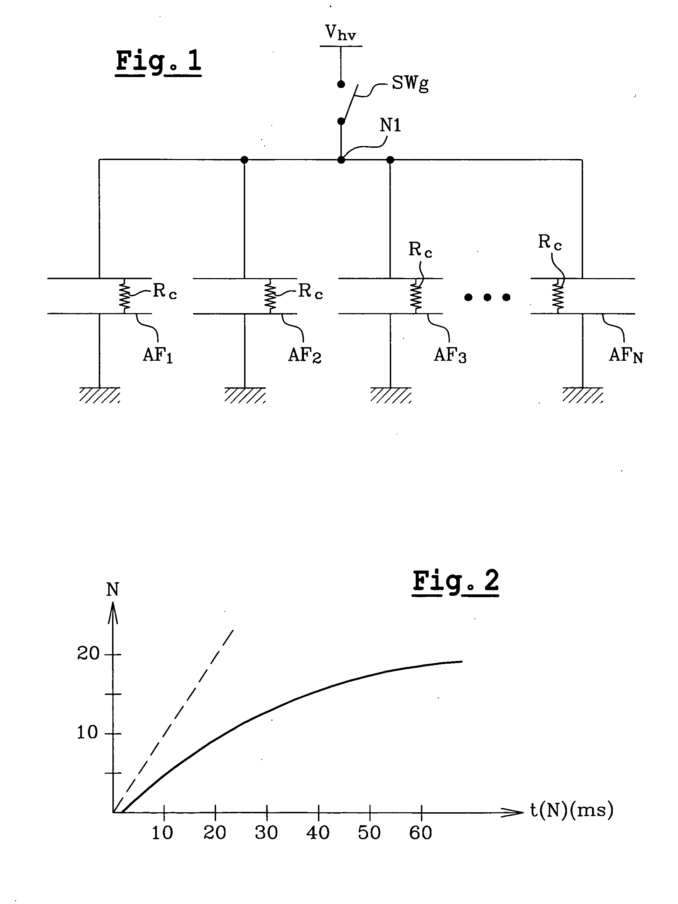

A titre de rappel, la figure 1 illustre l'agencement classique de N éléments antifusible AF1, AF2... $AF_N$ pendant le claquage des éléments antifusible. Les éléments antifusible sont représentés comme des condensateurs et le matériau isolant présent entre les électrodes des condensateurs forme l'élément antifusible à proprement parler. Les cathodes des éléments antifusible sont reliées à la masse et les anodes sont reliées à un noeud commun N1. Le noeud N1 est relié à une source de tension Vhv par l'intermédiaire d'un interrupteur SWg. L'interrupteur SWg est fermé pendant un temps t (N) prédéterminé, pendant lequel les éléments antifusible reçoivent la tension de claquage Vhv sur leurs anodes. Le claquage du matériau antifusible fait apparaître entre les électrodes une résistance série Rc qui rend l'élément antifusible conducteur.

En pratique, ces éléments antifusible sont agencés dans une rangée de cellules mémoire comprenant des moyens de sélection, d'accès et de lecture qui ne sont pas représentés ici dans un souci de simplicité, la programmation de la rangée de cellules mémoire correspondant au claquage des éléments antifusible.

La figure 2 représente une courbe donnant le temps de claquage t(N) en fonction du nombre N d'éléments antifusible claqués collectivement. Il apparaît que le temps t(N) n'est pas constant et dépend du nombre N. Plus particulièrement, cette courbe n'est pas linéaire et tend à croître de façon pseudo-exponentielle avec le nombre N.

Ainsi, la présente invention vise à réduire le temps de claquage d'un groupe de N éléments antifusible.

Plus particulièrement, la présente invention vise à résoudre le problème que représente l'augmentation rapide du temps de claquage en fonction du nombre N d'éléments antifusible à claquer.

De façon générale, la présente invention vise un procédé de programmation de cellules mémoire antifusible permettant de diminuer le temps de claquage d'un groupe de N éléments antifusible.

Pour atteindre ces objectifs, la présente invention prévoit un procédé de programmation d'une rangée de cellules mémoire antifusible en parallèle comprenant une étape de claquage d'au moins N éléments antifusible présents dans les cellules mémoire, le claquage d'un élément antifusible comprenant l'application d'une tension de claquage sur l'anode de l'élément antifusible, dans lequel les éléments antifusible sont claqués séquentiellement par groupes de P éléments antifusible avec P inférieur à N et au moins égal à 1, les éléments antifusible d'un même groupe recevant la tension de claquage simultanément, le claquage d'un groupe d'éléments antifusible suivant intervenant immédiatement après le claquage d'un groupe d'éléments antifusible précédent.

Selon un mode de réalisation P est égal à 1, les éléments antifusible étant claqués individuellement les uns après les autres.

Selon un mode de réalisation, P est choisi parmi plusieurs valeurs possibles de manière que le temps total de claquage des N éléments antifusible soit optimal.

Selon un mode de réalisation, le nombre P d'éléments antifusible claqués simultanément n'est pas constant pendant la programmation de la rangée de cellules mémoire.

Selon un mode de réalisation, le procédé comprend une étape de détection du claquage des éléments antifusible.

Selon un mode de réalisation, P éléments antifusible suivants ne sont pas claqués tant que le claquage de P éléments antifusible précédents n'a pas été détecté.

Selon un mode de réalisation, le claquage d'un élément antifusible est détecté lorsqu'une tension supérieure à un seuil déterminé apparaît sur la cathode de l'élément antifusible pendant que son anode reçoit la tension de claquage.

Selon un mode de réalisation, le procédé est appliqué à une mémoire comprenant des rangées de cellules agencées en lignes de mot et en lignes de bit, la programmation d'une rangée de cellules comprenant la sélection d'une ligne de mot et l'application séquentielle de la tension de claquage aux lignes de bit, par groupes de P lignes de bit recevant simultanément la tension de claquage.

Selon un mode de réalisation, le procédé est appliqué à une rangée de cellules mémoire antifusible ayant une architecture différentielle et comprenant chacune deux éléments antifusible, la programmation de chaque cellule comprenant le claquage d'un élément antifusible choisi parmi les deux éléments antifusible de la cellule en fonction de la valeur d'une donnée binaire à programmer, le claquage de la rangée de cellules comprenant le claquage séquentiel d'un seul élément antifusible dans chaque cellule de la rangée.

La présente invention concerne également une mémoire antifusible en circuit intégré comprenant au moins une rangée de cellules mémoire antifusible en parallèle, les cellules mémoire étant programmables par claquage de N éléments antifusible présents dans les cellules mémoire, des moyens de programmation de la rangée de cellules par application d'une tension de claquage sur une anode de chaque élément antifusible à claquer, dans laquelle les moyens de programmation comprennent des moyens pour appliquer séquentiellement la tension de claquage à des groupes de P éléments antifusible, P étant inférieur à N et au moins égal à 1, les éléments antifusible d'un même groupe recevant la tension de claquage simultanément, le claquage d'un groupe d'éléments antifusible suivant intervenant immédiatement après le claquage d'un groupe d'éléments antifusible précédent.

Selon un mode de réalisation, P est égal à 1 et les moyens de programmation sont agencés pour appliquer individuellement la tension de claquage aux éléments antifusible, de manière à claquer les éléments antifusible les uns après les autres.

Selon un mode de réalisation, le nombre P d'éléments antifusible dans les groupes d'éléments antifusible claqués simultanément n'est pas constant pendant la programmation d'une rangée de cellules mémoire.

Selon un mode de réalisation, la mémoire comprend des moyens de détection du claquage d'éléments antifusible, délivrant un signal de détection de claquage.

Selon un mode de réalisation, les moyens de programmation sont agencés pour ne pas appliquer pas la tension de claquage à un groupe d'éléments antifusible suivant tant que le claquage d'un groupe précédent n'est pas détecté.

Selon un mode de réalisation, les moyens de détection comprennent au moins un comparateur comprenant une première entrée reliée à la cathode d'au moins un élément antifusible, une deuxième entrée recevant une tension de référence et une sortie délivrant le signal de détection de claquage.

Selon un mode de réalisation, la mémoire comprend un circuit séquenceur et des interrupteurs pilotés par le circuit séquenceur pour appliquer séquentiellement la tension de claquage aux éléments antifusible, le circuit séquenceur recevant le signal de détection de claquage.

Selon un mode de réalisation, la mémoire comprend plusieurs rangées de cellules agencées en lignes de mot et en lignes de bit, chaque ligne de bit comprenant une ligne de distribution de la tension de claquage, les moyens de programmation étant agencés pour sélectionner une ligne de mot et appliquer séquentiellement la tension de claquage aux lignes de distribution des lignes de bit, par groupes de P lignes de bit recevant simultanément la tension de claquage.

Selon un mode de réalisation, la mémoire comprend des cellules mémoire ayant une architecture différentielle et comprenant chacune deux éléments antifusible en parallèle, et des interrupteurs de sélection d'un élément antifusible à claquer parmi les deux en fonction de la valeur d'une donnée binaire à enregistrer.

Ces objets, caractéristiques et avantages ainsi que d'autres de la présente invention seront exposés plus en détail dans la description suivante du procédé de l'invention et d'un exemple de réalisation d'une mémoire antifusible selon l'invention, faite à titre non limitatif en relation avec les figures jointes parmi lesquelles :

- la figure 1 précédemment décrite illustre un procédé de claquage classique d'une rangée d'éléments antifusible,

- la figure 2 précédemment décrite est une courbe représentant le temps de claquage collectif d'éléments antifusible en fonction du nombre d'éléments antifusible,

- la figure 3 illustre le procédé de claquage d'éléments antifusible selon l'invention,

- la figure 4 représente sous forme de blocs une mémoire antifusible selon l'invention,

- la figure 5 est le schéma électrique d'une cellule mémoire antifusible présente dans la mémoire de la figure 4,

- la figure 6 est un schéma plus détaillé d'un plan mémoire et de certains autres éléments de la mémoire de la figure 4, et

- la figure 7 est un diagramme d'états d'un séquenceur de programmation selon l'invention, représenté sous forme de bloc en figure 4.

**Description du procédé**

Premier aspect du procédé

Selon des constatations et hypothèses entrant dans le cadre de la présente invention, la relation non linéaire existant entre le temps de claquage $t(N)$ et le nombre $N$ d'éléments antifusible à claquer collectivement est due au fait que le temps de claquage d'un élément antifusible considéré individuellement dépend de l'intensité du courant disponible pour le claquage, et est d'autant plus long que ce courant est faible. Or, lorsqu'une tension de claquage $Vhv$ est appliquée sur les anodes de $N$ éléments antifusible $AF1$, $AF2...AF_N$ en parallèle, comme illustré en figure 1, tous les éléments antifusible ne claquent pas exactement au même moment. Si l'on observe des éléments antifusible entre le commencement et la fin d'un processus de claquage collectif, il apparaît que le nombre d'éléments antifusible claqués croit progressivement jusqu'à ce que tous soient claqués. Ainsi, lorsque le nombre d'éléments antifusible à claquer est important, le courant délivré par la source de tension tend à se répartir dans les éléments antifusible déjà claqués, au détriment de ceux qui ne le sont pas encore. Plus le nombre d'éléments à claquer est élevé, plus les derniers éléments antifusible sont long à claquer car la source de tension est affaiblie par le courant délivré dans les éléments antifusible déjà claqués.

La présente invention se base sur l'idée simple mais non moins inventive de limiter le nombre d'éléments à claquer simultanément en subdivisant un groupe de $N$ éléments antifusible à claquer en $N/P$ groupes de $P$ éléments antifusible, et en procédant à $N/P$ cycles de claquage de $P$ éléments antifusible. En désignant par $t(P)$ le temps de claquage collectif de $P$ éléments antifusible, et par $TP$ la durée totale du claquage selon le procédé de l'invention, on peut écrire que : '

$$(1) \ TP = t(P)+t(P)+.....+t(P) = (N/P)^*t(P) < t(N)$$

$N/P$ étant le nombre de cycles de claquage à prévoir pour obtenir le claquage des $N$ éléments antifusible, $t(N)$ étant le temps de claquage collectif des $N$ éléments antifusible (temps de claquage selon l'art antérieur).

Le nombre $P$ est de préférence choisi de manière que le temps total de claquage $TP$ soit optimal. Ainsi, en désignant par $t(P+1)$ le temps de claquage collectif de $P+1$ éléments antifusible, et par $t(P-1)$ le temps de claquage collectif de $P-1$ éléments antifusible, $P$ est choisi de manière que :

$$(2) \ TP = (N/P)^*t(P) < (N/(P-1))^*t(P-1)$$

et que

$$(3) \ TP = (N/P)^*t(P) < (N/(P+1))^*t(P+1)$$

Choix d'un nombre P

En l'état de la technologie, on a constaté que le nombre $P$ optimal est égal à 1. En effet le temps de claquage d'un élément antifusible isolé est statistiquement plus court que la moitié du temps de claquage de deux éléments antifusible et est bien évidemment beaucoup plus court que le temps de claquage de $N$ éléments antifusible divisé par $N$. Outre les limitations de la source de tension/courant, ceci est dû également à des limitations concernant la taille des interrupteurs ("switchs") et le dimensionnement des pistes conductrices utilisés pour distribuer la haute tension, qui doivent supporter la somme de tous les courants de claquage.

Ainsi, dans ce qui suit, des exemples de mise en oeuvre de l'invention seront décrits en choisissant $P=1$.

Le nombre $P$ optimal étant toutefois dépendant de divers paramètres technologiques, de la sortance du circuit survolteur délivrant la tension de claquage $Vhv$ (son aptitude à délivrer du courant), etc., ce choix ne constitue qu'un exemple non limitatif.

A titre d'exemple numérique, le temps de claquage d'un élément antifusible en oxyde est de 0,5 ms tandis que le temps de claquage de 20 éléments antifusible est de 50 ms. On a donc dans ce cas :

$$(4) \ TP = N/1^*t(P{=}1) = 20/1 * 0,5 \ ms = 10 \ ms$$

$$(5) \ t(N{=}20) = 50 \ ms$$

soit une durée de claquage de 10 ms comprenant vingt cycles de claquage de 0,5 ms chacun, au lieu d'une durée de 50 ms pour le claquage collectif de 20 éléments antifusible.

Deuxième aspect du procédé

Un obstacle à la mise en oeuvre du premier aspect de l'invention réside dans la détermination du temps de claquage $t(P)$ à appliquer à chacun des groupes de $P$ éléments antifusible. Bien qu'une détermination expérimentale de $t(P)$ soit envisageable, les dérives de la technologie entre lots de circuits intégrés risquent de rendre ce temps insuffisant. Inversement, le choix à titre de précaution d'un temps $t(P)$ très long pourrait faire perdre tout ou partie des avantages du procédé de l'invention.

Ainsi, selon un deuxième aspect de l'invention, on propose que la durée de claquage d'un groupe de P éléments antifusible soit déterminée en temps réel grâce à une détection du claquage de chaque élément antifusible. Selon l'invention, la détection du claquage de chaque élément antifusible est obtenue en observant la tension présente sur la cathode de l'élément antifusible, pendant que celui-ci reçoit la tension Vhv sur son anode. Tant que la tension de cathode est flottante, l'élément antifusible est électriquement isolant et n'est pas claqué. Lorsque le claquage commence, l'élément antifusible devient conducteur bien qu'encore fortement résistif et la tension de cathode commence à monter. Le claquage est considéré comme détecté lorsque la tension de cathode atteint une valeur déterminée Vref, qui correspond à une certaine valeur de résistance électrique de l'élément antifusible. Afin que cette tension de cathode puisse être valablement utilisée aux fins de la présente invention, un élément résistif et/ou capacitif doit de préférence être prévu sur la cathode, afin de former avec l'élément antifusible un pont diviseur de tension. Comme cela apparaîtra plus loin, cet élément résistif et/ou capacitif est généralement présent du seul fait de la présence de transistors de sélection reliant les cathodes des éléments antifusible à la masse.

**Exemple de mise en oeuvre du procédé**

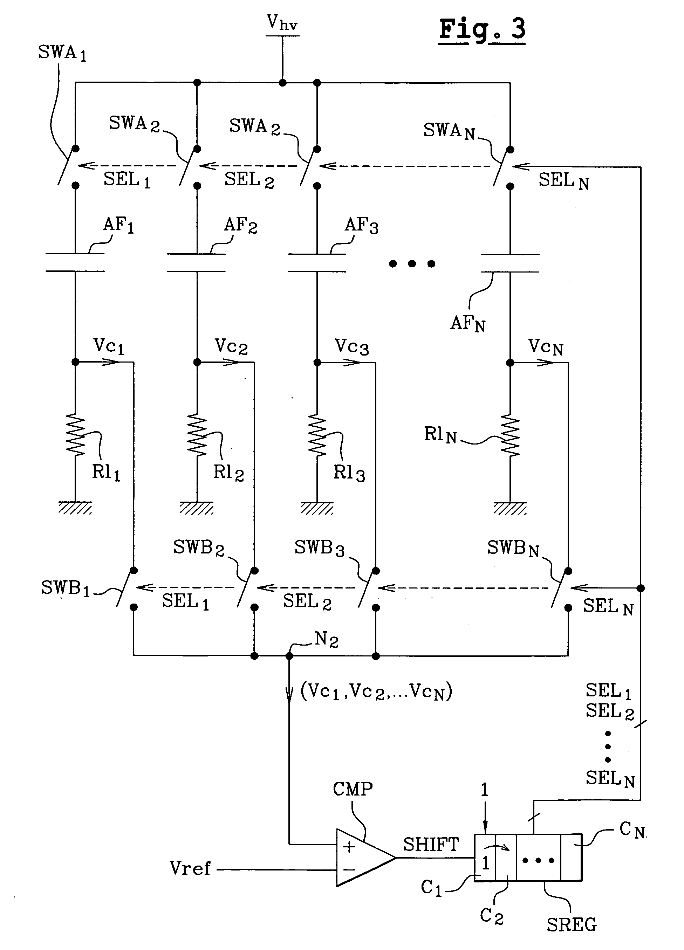

La figure 3 représente un exemple de mise en oeuvre conjointe des deux aspects du procédé de l'invention, dans le cas ou P=1. On retrouve les N éléments antifusible AF1 à $AF_N$ de la figure 1 dont les anodes sont reliées au noeud N1 recevant la tension de claquage Vhv. Selon l'invention, l'interrupteur général SWg reliant le noeud N1 à la tension Vhv est supprimé et est remplacé par N interrupteurs individuels SWA1, SWA2, SWA3...$SWA_N$ agencés chacun entre l'anode d'un élément antifusible et le noeud N1.

La cathode de chaque élément antifusible est reliée ici à la masse par l'intermédiaire d'une résistance, respectivement R11, R12, R13...$R1_N$. Cette résistance correspond généralement à la résistance drain-source d'un transistor de sélection de l'élément antifusible, comme cela apparaîtra plus loin dans la description d'un exemple de mémoire antifusible selon l'invention.

Selon l'invention toujours, la cathode de chaque élément antifusible est également reliée à un noeud N2 par l'intermédiaire d'un interrupteur individuel, respectivement SWB1, SWB2, SWB3...$SWB_N$. Le noeud N2 est connecté à l'entrée positive d'un comparateur CMP dont l'entrée négative reçoit la tension Vref. La sortie du comparateur CMP délivre un signal SHIFT qui est appliqué sur une entrée de commande de décalage d'un registre à décalage SREG comprenant N cellules en cascade C1, C2...$C_N$. Le registre à décalage comprend N sorties correspondant chacune à une cellule, délivrant respectivement des signaux SEL1, SEL2, SEL3,... $SEL_N$. Le signal SEL1 pilote les interrupteurs SWA1 et SWB1, le signal SEL2 pilote les interrupteurs SWA2 et SWB2, etc.., le signal $SEL_N$ pilotant les interrupteurs $SWA_N$ et $SWB_N$.

Le processus de claquage des N éléments antifusible se déroule comme suit. Le registre SREG est mis à 0, la tension de claquage Vhv est appliquée sur le noeud N1 et un bit à "1" est chargé dans la première cellule C1 du registre SREG. Le signal SEL1 passe à 1, les autres signaux SEL2... $SEL_N$ étant à 0, de sorte que les interrupteurs SWA1, SWB1 se ferment. La tension Vhv se retrouve sur l'anode du premier élément antifusible AF1, dont la cathode est reliée à l'entrée positive du comparateur CMP. Lorsque l'élément AF1 commence à devenir conducteur, une tension de cathode Vc1 apparaît. Lorsque la tension de cathode Vc1 atteint le seuil Vref, le signal SHIFT à la sortie du comparateur passe à 1. Le bit à 1 se décale dans la cellule suivante C2 tandis que la cellule C1 repasse à 0. Le signal SEL2 passe à 1, le signal SEL1 repasse à 0 et les autres signaux SEL3... $SEL_N$ restent à 0. Les interrupteurs SWA1, SWB1 s'ouvrent et les interrupteurs SWA2, SWB2 se ferment. La tension Vhv se retrouve sur l'anode du deuxième élément antifusible AF2 et la cathode de l'élément antifusible AF2 est reliée à l'entrée positive du comparateur CMP. Une tension de cathode Vc2 apparaît et provoque un nouveau décalage du registre SREG. Le processus se poursuit ainsi jusqu'à ce que tous les éléments antifusible soient claqués.

Ainsi, le comparateur CMP et les interrupteurs SWB1 à $SWB_N$ permettent de détecter le claquage de chaque élément, et de contrôler le passage au cycle de claquage suivant. Le temps conféré à chaque cycle de claquage est ainsi asservi à sa valeur minimale, qui peut être différente d'un élément antifusible à l'autre.

Comme indiqué plus haut, le seuil Vref correspond à une certaine valeur de résistance électrique de l'élément antifusible, une résistance inférieure à 100 KΩ étant considérée en pratique comme représentative d'un claquage satisfaisant. Pour calculer le seuil Vref, on tient compte du fait que l'élément antifusible claqué forme avec la résistance série R11 à $R1_N$ un pont diviseur de tension. En pratique, une tension Vref représentant 20% de la tension Vhv, soit 2V pour une tension Vhv de 10V, peut être choisie.

**Exemple de mémoire antifusible selon l'invention**

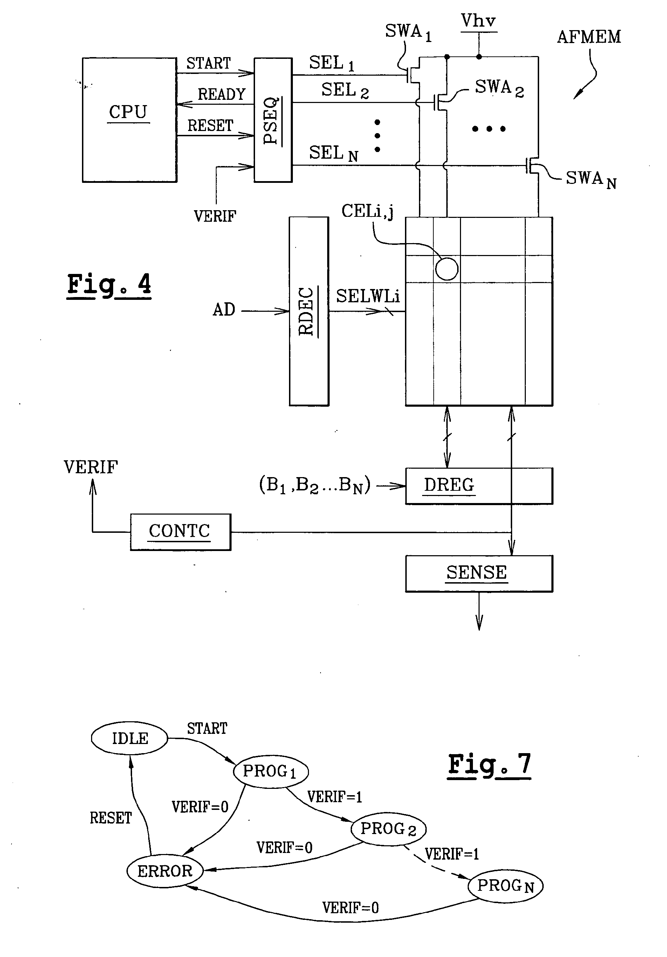

La figure 4 représente un exemple de réalisation en technologie CMOS d'une mémoire antifusible AFMEM selon l'invention. La mémoire AFMEM comprend classiquement un plan mémoire MA ("memory array") comprenant des cellules mémoire antifusible CELi, j, un décodeur de ligne RDEC recevant en entrée une adresse de ligne AD, un registre de données DREG ("data register"), un circuit de lecture SENSE et une unité centrale CPU. La mémoire AEMEM est implémentée ici dans un circuit intégré comprenant une unité centrale ou CPU contrôlant les opérations d'écriture et de lecture de la mémoire. Ainsi, le CPU charge dans le registre DREG des données à enregistrer dans le plan mémoire et lit en sortie du circuit SENSE des données lues dans la plan mémoire.

Selon l'invention, la mémoire comprend les interrupteurs SWA1 à SWA$_N$ décrits plus haut, un séquenceur de programmation PSEQ à logique câblée pour piloter les interrupteurs SWA, et un circuit de contrôle CONTC pour contrôler le processus de claquage d'éléments antifusible et délivrer un signal VERIF appliqué au séquenceur PSEQ. Les interrupteurs SWA1 à SWA$_N$ sont ici des transistors MOS reliés par leur drain au noeud N1 qui reçoit la tension Vhv. Le séquenceur délivre les signaux de sélection SEL1, SEL2....SEL$_N$ décrits plus haut, de manière à rendre passants les uns après les autres les transistors SWA1 à SWA$_N$.

Architecture des cellules mémoire

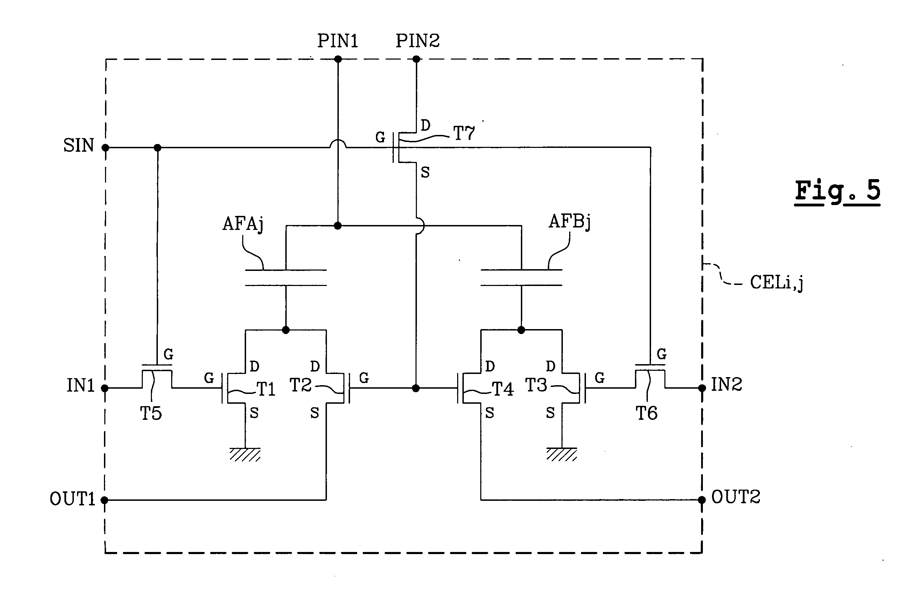

La figure 5 représente l'architecture d'une cellule mémoire antifusible CELi,j, ici une architecture différentielle commune à toutes les cellules du plan mémoire. La cellule mémoire comprend deux éléments antifusible AFAj, AFBj. Les anodes des éléments AFAj, AFBj sont reliées à une entrée PIN1 de la cellule. La cathode de l'élément AFAj est reliée au drain d'un transistor T1 dont la source est connectée à la masse, et au drain d'un transistor T2 dont la source est connectée à une sortie OUT1 de la cellule. De façon similaire, la cathode de l'élément AFBj est reliée au drain d'un transistor T3 dont la source est connectée à la masse, et au drain d'un transistor T4 dont la source est connectée à une sortie OUT2 de la cellule. La grille du transistor T1 est reliée à une entrée IN1 de la cellule par l'intermédiaire d'un transistor T5. La grille du transistor T3 est reliée à une entrée IN2 de la cellule par l'intermédiaire d'un transistor T6. Les grilles des transistors T5, T6 sont connectées à une entrée SIN de la cellule. Les grilles des transistors T2, T4 sont reliées à une entrée PIN2 de la cellule par l'intermédiaire d'un transistor T7 dont la grille est connectée à l'entrée SIN.

La sélection d'une cellule mémoire en écriture ou en lecture est faite en appliquant un signal de sélection à 1 (tension d'alimentation Vcc du circuit intégré) sur l'entrée SIN de la cellule, ce qui rend les transistors T5, T6, T7 passants.

Programmation d'une cellule mémoire

L'écriture d'un bit Bi dans une cellule mémoire est faite en appliquant le bit Bi sur l'entrée IN1 et le bit inverse /Bi sur l'entrée IN2. La tension de claquage Vhv est appliquée sur l'entrée PIN1 et provoque le claquage de l'élément AFAj ou de l'élément AFBj selon que le bit Bi est à 1 (transistor T1 passant) ou à 0 (bit /Bi à 1, transistor T3 passant). Selon l'invention, le claquage de l'élément AFAj ou AFBj est détecté par une surveillance de sa tension de cathode, via le transistor T2 ou T4 et la sortie OUT1 ou OUT2 de la cellule. Ainsi, la paire de transistors T2, T4 est utilisée pendant le processus de programmation comme l'un des interrupteurs SWB (SWB1 à SWB$_N$) décrit plus haut (fig. 3).

Lecture d'une cellule mémoire

La lecture d'un bit dans la cellule mémoire est faite en appliquant une tension Vread sur ses entrées PIN1 et PIN2, et en observant les sorties OUT1 et OUT2. Si la sortie OUT1 est à 1 (tension Vread) et la sortie OUT2 à 0, cela signifie que la donnée chargée dans la cellule mémoire est le "1" logique (élément AFAj claqué). Si la sortie OUT1 est à 0 et la sortie OUT2 à 1, cela signifie que la donnée chargée dans la cellule mémoire est le "0" logique (élément AFBj claqué).

Architecture du plan mémoire

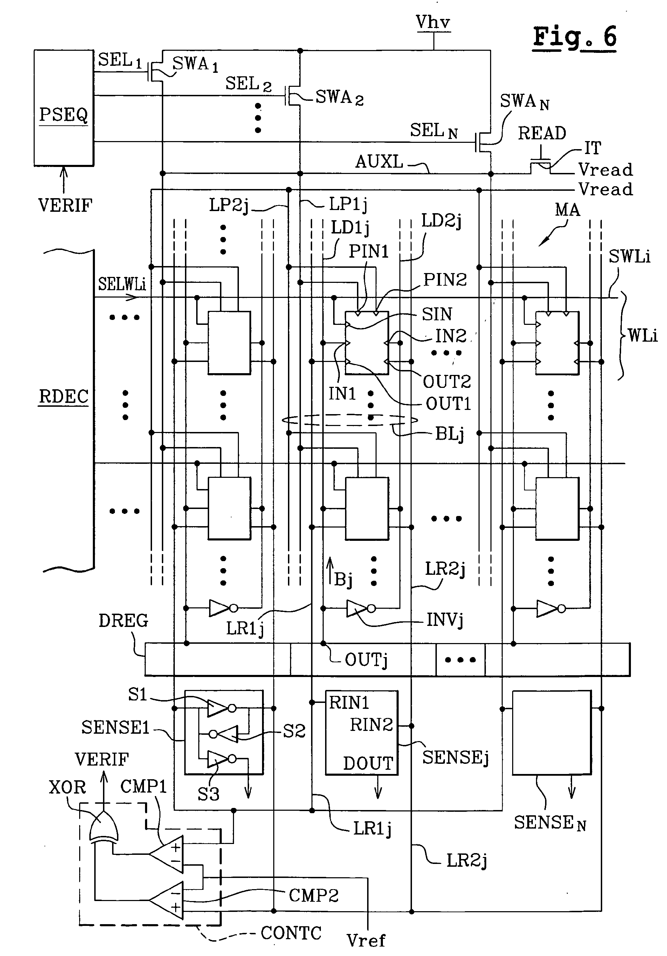

La figure 6 représente plus en détail l'architecture du plan mémoire MA ainsi que celles du circuit CONTC et du circuit SENSE.

Le circuit SENSE comprend des amplificateurs de lecture SENSE1, SENSE2...SENSE$_N$ comprenant chacun deux entrées RIN1, RIN2 et une sortie DOUT (voir SENSEj sur la figure). Chaque amplificateur de lecture comprend par exemple trois portes inverseuses S1, S2, S3 (voir SENSE1 sur la figure). Les portes S1, S2 sont connectées tête-bêche, l'entrée de la porte S1 étant connectée à l'entrée RIN1 et l'entrée de la porte S2 connectée à l'entrée RIN2. La porte S3 a son entrée connectée à la sortie de l'une des portes S1, S2 et sa sortie forme la sortie DOUT de l'amplificateur de lecture.

Le circuit CONTC comprend deux comparateurs CMP1, CMP2 recevant sur leurs entrées négatives la tension Vref. Les sorties des comparateurs sont appliquées à l'entrée d'une porte XOR (OU EXCLUSIF) dont la sortie délivre le signal VERIF.

Dans le plan mémoire MA, les cellules mémoire antifusible différentielles CELi,j sont agencées en N lignes de bit BLj (BL1, BL2,...BL$_N$) et en K lignes de mot WLi, pour former des rangées de N cellules mémoire chacune, une rangée correspondant à une ligne de mot.

Chaque ligne de mot WLi comprend une ligne de sélection SWLi connectée aux entrées SIN des cellules mémoire de la ligne de mot. La ligne SWLi reçoit un signal de sélection SELWLi délivré par le décodeur RDEC, qui est à 1 lorsque l'adresse reçue correspond à la ligne de mot considérée.

Chaque ligne de bit BLj comprend :

- une première ligne de distribution de tension LP1j, connectée aux entrées PIN1 des cellules de la ligne de bit,
- une deuxième ligne de distribution de tension LP2j connectée aux entrées PIN2 des cellules de la ligne de bit,
- une ligne de données LD1j reliant une sortie OUTj du registre DREG aux entrées IN2 des cellules de la ligne de bit,

- une ligne de données LD2j reliant, par l'intermédiaire d'une porte inverseuse INVj, la sortie OUTj du registre DREG aux entrées IN2 des cellules de la ligne de bit,
- une ligne de lecture LR1j reliant les sorties OUT1 des cellules de la ligne de bit à l'entrée RIN1 d'un amplificateur de lecture SENSEj, et
- une ligne de lecture LR2j reliant les sorties OUT1 des cellules de la ligne de bit à une entrée RIN2 de l'amplificateur de lecture SENSEj.

Selon l'invention, chaque ligne de lecture LR1j est connectée à l'entrée positive du comparateur CMP1 et chaque ligne de lecture LR2j est connectée à l'entrée positive du comparateur CMP2. Chaque ligne de distribution LP1j est connectée au noeud N1 par l'intermédiaire d'un transistor SWAj de rang j correspondant (SWA1, SWA2,...SWA$_N$). Les lignes LP1j sont également connectées à une ligne auxiliaire commune AUXL, permettant d'appliquer la tension Vread aux lignes LP1j pendant des phases de lecture. La tension Vread est appliquée à la ligne AUXL par l'intermédiaire d'un transistor d'isolement IT piloté par un signal READ.

La sélection d'une rangée de cellules mémoire en écriture ou en lecture est faite en appliquant une adresse AD au décodeur RDEC. Celui-ci délivre alors un signal de sélection SELWLi égal à 1 (tension d'alimentation Vcc du circuit intégré) sur la ligne SWLi désignée par l'adresse AD. Le signal SELWLi se retrouve sur les entrées SIN des cellules de la ligne de mot, ce qui rend les transistors T5, T6, T7 passants dans chacune des cellules.

## Lecture d'une rangée de cellules

La lecture de cellules mémoire s'effectue en appliquant la tension Vread sur les lignes LP1j (via la ligne AUXL) et sur les lignes LP2j, et en sélectionnant une ligne de mot à lire au moyen du décodeur RDEC. Les cellules sélectionnées ont chacune une sortie OUT1 ou OUT2 qui passe à 1, et chacun des amplificateurs de lecture SENSE1 à SENSE$_N$ délivre une donnée.

## Ecriture d'une rangée de cellules

L'écriture d'une donnée dans une ligne de mot WLi sélectionnée par le décodeur RDEC est obtenue en programmant chacune des cellules de la ligne de mot, la programmation de chaque cellule correspondant au claquage d'un élément antifusible AFA ou AFB. La donnée est préalablement enregistrée dans le registre DREG. Cette donnée prend la forme d'une suite de bits B1, B2, ... B$_N$, chaque bit Bj étant appliqué sur une ligne LDlj et chaque bit inversé /Bj appliqué sur une ligne LD2j. La tension Vhv est appliquée sur le noeud N1. Selon l'invention, la tension Vread est également appliquée sur les lignes LP2j afin que les transistors T2, T4 des cellules sélectionnées (fig. 5) soient passants et que les sorties OUT1, OUT2 délivrent une tension d'anode permettant aux comparateurs CMP1, CMP2 de contrôler le processus de claquage. Il va de soi que toute autre tension permettant de rendre passant les transistors T2, T4 pourrait être utilisée.

Le CPU applique un signal START au séquenceur PSEQ, qui met alors le signal SEL1 à 1, tous les autres signaux SEL2 à SEL$_N$ restant à 0. Seul le transistor SWA1 est passant et seule la première cellule de la rangée à programmer reçoit la tension Vhv. L'un des deux éléments antifusible AFAj, AFBj reçoit la tension Vhv, selon la valeur de la donnée présente sur les entrées IN1, IN2 (bits B1 et /B1). Lorsque l'élément AFAj ou AFBj est claqué, la tension de cathode présente sur l'entrée positive de l'un des comparateurs CMP1, CMP2 fait basculer la sortie d'un comparateur à 1 tandis que la sortie de l'autre comparateur reste à 0. Le signal VERIF passe à 1, ce qui déclenche le cycle de programmation de la cellule suivante. Le séquenceur PSEQ met alors à 1 le signal SEL2 et remet à 0 le signal SEL1, tous les autres signaux SEL3 à SEL$_N$ restant à 0. Le transistor SWA2 devient passant et la deuxième cellule de la rangée à programmer reçoit la tension Vhv. Lorsque un élément antifusible de la deuxième cellule est claqué, le signal VERIF repasse à 1 et déclenche le cycle de programmation de la cellule suivante, ainsi de suite jusqu'à ce que les N cellules soient programmées. Lorsque la dernière cellule est programmée, le séquenceur envoie un signal READY.

Le séquenceur PSEQ est par exemple réalisé à partir du diagramme d'états représenté en figure 7. Le séquenceur présente un état de repos IDLE et. bascule dans un état PROG1 (programmation de la première cellule) sur réception du signal START. Le séquenceur bascule dans un état PROG2 (programmation de la seconde cellule) sur réception du signal VERIF à 1, puis bascule dans un état PROG3 sur réception du signal VERIF à 1, et ainsi de suite jusqu'à un état PROG$_N$. Le séquenceur dans l'état PROG$_N$ retourne à l'état IDLE en émettant le signal READY lorsque le signal VERIF passe à 1. Une temporisation peut être prévue dans l'hypothèse où une cellule ne parviendrait pas à être programmée (élément antifusible n'atteignant jamais l'état claqué). Dans ce cas, si le signal VERIF reste à 0 un certain temps après basculement dans l'un des états PROG1, PROG2,... PROG$_N$, le séquenceur bascule dans un état ERROR où il n'émet pas le signal READY, et ne peut être remis dans l'état IDLE que par l'application d'un signal RESET.

Le séquenceur de programmation est bien entendu susceptible de diverses autres variantes de réalisation et peut également prendre la forme d'un registre à décalage, comme décrit plus haut, le signal VERIF étant alors utilisé comme signal de décalage (SHIFT) .

Il apparaîtra clairement à l'homme de l'art que le procédé selon l'invention est susceptible de diverses variantes. Le séquenceur PSEQ pourrait par exemple piloter les transistors SWA1 à SWA$_N$ par paires pour la programmation simultanée de deux cellules mémoire (P=2), ou les piloter par groupes de trois (P=3) ou plus. D'autre part, le nombre P d'éléments antifusible dans chaque groupe d'éléments antifusible claqués simultanément peut n'être pas constant pendant la programmation d'une rangée de cellules mémoire. Ainsi, si le rapport N/P n'est pas un nombre entier le dernier groupe de cellules simultanément programmé peut être égal au reste de la division de N par P. Par exemple, si une rangée de cellules comprend 10 cellules et que la programmation est effectuée par groupes de trois, on pourra prévoir trois cycles de programmation simultanée de trois cellules suivis d'un cycle de programmation d'une seule cellule.

On notera qu'une programmation individuelle (P=1) ne nécessite de prévoir que deux comparateurs CMP1, CMP2. Si une programmation par paires est prévue, deux circuits CONTC comprenant chacun deux comparateurs CMP1, CMP2 devront être prévus pour contrôler simultanément le claquage des éléments antifusible dans les deux cellules, et ainsi de suite selon le nombre P de cellules programmées simultanément.

Ainsi, un autre avantage d'avoir P=1 est qu'un seul moyen de détection peut être utilisé pour détecter le claquage de tous les éléments antifusible, ceux-ci étant claqués les uns après les autres. Ainsi, même si 1 n'est pas la valeur optimale de P en termes de temps global de programmation, cette valeur peut être choisie pour la simplification des moyens de détection. Il s'agit alors d'un compromis entre le temps total de claquage et la simplicité de mise en oeuvre du deuxième aspect du procédé.

D'autre part, bien que l'on ait proposé dans ce qui précède d'utiliser les transistors de lecture T2, T4 et les sorties OUT1, OUT2 des cellules pour surveiller la tension de cathode pendant le processus de claquage, des transistors spécifiques et des sorties spécifiques pourraient être prévus à cet effet dans les cellules.

Egalement, bien que l'on ait proposé dans ce qui précède d'appliquer la tension Vread sur les grilles des transistors T2, T4 pendant le processus de claquage, pour rendre ceux-ci conducteurs et surveiller la tension de cathode des éléments antifusible à partir des sorties OUT1 et OUT2, une autre tension de contrôle pourrait leur être appliquée, par exemple la tension Vhv.

D'autre part, la présente invention est applicable à diverses architectures de mémoires antifusible. Bien que la mémoire décrite ci-dessus ne comprenne qu'une colonne de N lignes de bit, une mémoire antifusible selon l'invention peut aussi comprendre plusieurs colonnes de N lignes de bit chacune.

Enfin, divers autres moyens peuvent être prévus pour surveiller la tension de cathode, par exemple des portes logiques ayant des seuils de commutation déterminés, des amplificateurs différentiels, etc..

**Exemple de résultat obtenu**

Supposons ici que la mémoire comprenne 10 lignes de mot de 20 bits chacune (soit 20 lignes de bit, N=20), que le temps de claquage collectif de 20 éléments antifusible soit de 50 ms et que le temps de claquage individuel d'un élément antifusible soit de 0,5 ms, comme indiqué plus haut.

Dans ce cas, le temps de sélection des cellules mémoire étant négligeable devant le temps de programmation, le temps nécessaire pour claquer 200 éléments antifusible est de l'ordre de 200*0,5 soit 100 ms avec le procédé selon l'invention. Ce temps de claquage est de l'ordre de 50 ms*10 soit 500 ms avec le procédé selon l'art antérieur. Le gain en termes de temps de programmation est ainsi de 400 ms pour le claquage de 200 éléments antifusible.

**Revendications**

1. Procédé de programmation d'une rangée de cellules mémoire antifusible en parallèle (CELi,j) comprenant une étape de claquage d'au moins N éléments antifusible (AF1-AF$_N$, AFAj, AFBj) présents dans les cellules mémoire, le claquage d'un élément antifusible comprenant l'application d'une tension de claquage (Vhv) sur l'anode de l'élément antifusible, **caractérisé en ce que** les éléments antifusible sont claqués séquentiellement par groupes de P éléments antifusible avec P inférieur à N et au moins égal à 1, les éléments antifusible d'un même groupe recevant la tension de claquage simultanément, le claquage d'un groupe d'éléments antifusible suivant intervenant immédiatement après le claquage d'un groupe d'éléments antifusible précédent.

2. Procédé selon la revendication 1, dans lequel P est égal à 1, les éléments antifusible étant claqués individuellement les uns après les autres.

3. Procédé selon l'une des revendications 1 et 2, dans lequel P est choisi parmi plusieurs valeurs possibles de manière que le temps total (TP) de claquage des N éléments antifusible soit optimal.

4. Procédé selon l'une des revendications 1 à 3, dans lequel le nombre P d'éléments antifusible claqués simultanément n'est pas constant pendant la programmation de la rangée de cellules mémoire.

5. Procédé selon l'une des revendications 1 à 4, comprenant une étape de détection (SHIFT, VERIF) du claquage des éléments antifusible.

6. Procédé selon la revendication 5, dans lequel P éléments antifusible suivants ne sont pas claqués tant que le claquage de P éléments antifusible précédents n'a pas été détecté (SHIFT, VERIF).

7. Procédé selon l'une des revendications 5 et 6, dans lequel le claquage d'un élément antifusible est détecté lorsqu'une tension supérieure à un seuil déterminé (Vref) apparaît sur la cathode de l'élément antifusible pendant que son anode reçoit la tension de claquage (Vhv).

8. Procédé selon l'une des revendications 1 à 7, appliqué à une mémoire (AFMEM) comprenant des rangées de cellules (CELi,j) agencées en lignes de mot (WLi) et en lignes de bit (BLj), la programmation d'une rangée de cellules comprenant la sélection (SELWLi) d'une ligne de mot et l'application séquentielle de la tension de claquage aux lignes de bit, par groupes de P lignes de bit recevant simultanément la tension de claquage.

9. Procédé selon l'une des revendications 1 à 8, appliqué à une rangée de cellules mémoire antifusible (CELi,j) ayant une architecture différentielle et comprenant chacune deux éléments antifusible (AFAj, AFBj), la programmation de chaque cellule comprenant le claquage d'un élément antifusible choisi parmi les deux éléments antifusible de la cellule en fonction de la valeur d'une donnée binaire à programmer (Bj, /Bj), le claquage de la rangée de cellules comprenant le claquage séquentiel d'un seul élément antifusible dans chaque cellule de la rangée.

10. Mémoire antifusible (AFMEM) en circuit intégré comprenant :

    - au moins une rangée de cellules mémoire antifusible en parallèle (CELi,j), les cellules mémoire étant programmables par claquage de N éléments antifusible (AF1-AF$_N$, AFAj, AFBj) présents dans les cellules mémoire,
    - des moyens de programmation de la rangée de cellules par application d'une tension de claquage (Vhv) sur une anode de chaque l'élément antifusible à claquer,

    **caractérisée en ce que** les moyens de programmation comprennent des moyens (PSEQ, SWA1-SWA$_N$) pour appliquer séquentiellement la tension de claquage à des groupes de P éléments antifusible, P étant inférieur à N et au moins égal à 1, les éléments antifusible d'un même groupe recevant la tension de claquage simultanément, le claquage d'un groupe d'éléments antifusible suivant intervenant immédiatement après le claquage d'un groupe d'éléments antifusible précédent.

11. Mémoire selon la revendication 10, dans laquelle P est égal à 1 et les moyens de programmation sont agencés pour appliquer individuellement la tension de claquage aux éléments antifusible, de manière à claquer les éléments antifusible les uns après les autres.

12. Mémoire selon l'une des revendications 10 et 11, dans laquelle le nombre P d'éléments antifusible dans les groupes d'éléments antifusible claqués simultanément n'est pas constant pendant la programmation d'une rangée de cellules mémoire.

13. Mémoire selon l'une des revendications 10 à 12, comprenant des moyens (CONTC, CMP, CMP1, CMP2) de détection du claquage d'éléments antifusible, délivrant un signal de détection de claquage (SHIFT, VERIF).

14. Mémoire selon la revendication 13, dans laquelle les moyens de programmation sont agencés pour ne pas appliquer pas la tension de claquage à un groupe d'éléments antifusible suivant tant que le claquage d'un groupe précédent n'est pas détecté.

15. Mémoire selon l'une des revendications 13 et 14, dans laquelle les moyens de détection comprennent au moins un comparateur (CMP, CMP1, CMP2) comprenant une première entrée reliée à la cathode d'au moins un élément antifusible (AF1-AF$_N$, AFAj, AFBj), une deuxième entrée recevant une tension de référence (Vref) et une sortie délivrant le signal de détection de claquage (SHIFT, VERIF).

16. Mémoire selon l'une des revendications 13 à 15, comprenant un circuit séquenceur (PSEQ, SREG) et des interrupteurs (SWA1-SWA$_N$) pilotés par le circuit séquenceur pour appliquer séquentiellement la tension de claquage aux éléments antifusible, le circuit séquenceur recevant le signal de détection de claquage (VERIF, SHIFT).

17. Mémoire selon l'une des revendications 10 à 16, comprenant plusieurs rangées de cellules agencées en lignes de mot (WLi) et en lignes de bit (BLj), chaque ligne de bit comprenant une ligne (LP1j) de distribution de la tension de claquage (Vhv), les moyens de programmation étant agencés pour sélectionner une ligne de mot (WLi) et appliquer séquentiellement la tension de claquage aux lignes de distribution des lignes de bit, par groupes de P lignes de bit recevant simultanément la tension de claquage.

18. Mémoire selon l'une des revendications 10 à 17, comprenant des cellules mémoire ayant une architecture différentielle et comprenant chacune deux éléments antifusible (AFAj, AFBj) en parallèle, et des interrupteurs (T1, T3) de sélection d'un élément antifusible à claquer parmi les deux en fonction de la valeur d'une donnée binaire (Bj, /Bj) à enregistrer.

## Fig. 1

## Fig. 2

Fig. 3

Fig. 4

Fig. 7

**Fig. 5**

**Fig. 6**

Office européen
des brevets

**RAPPORT DE RECHERCHE EUROPEENNE**

Numéro de la demande

EP 03 00 7639

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| P,X | US 2002/136076 A1 (SCHEUERLEIN ROY E ET AL) 26 septembre 2002 (2002-09-26) * alinéas [0016]-[0022]; revendications 1,13,34-36; figures 1,2 * * alinéas [0027]-[0029]; figures 7,8 * | 1-8, 10-17 | G11C17/18 |
| P,X | WO 02 078003 A (MATRIX SEMICONDUCTOR) 3 octobre 2002 (2002-10-03) * figures 8,10 * | 1,10 | |
| X | US 6 229 733 B1 (MALE BARRY) 8 mai 2001 (2001-05-08) | 1,2,10, 11 | |
| Y | * colonne 4, ligne 38 - colonne 6, ligne 6; figures 5,6 * | 5-9, 13-18 | |
| Y | US 5 684 732 A (SAKO NORIMITSU) 4 novembre 1997 (1997-11-04) | 5,6,8, 13,14, 16,17 | |
| A | * colonne 8, ligne 16 - colonne 12, ligne 12; figures 1,3 * * colonne 19, ligne 4 - ligne 58; revendications 7,8; figure 10 * | 1-4,7, 10-12,16 | |
| | | | DOMAINES TECHNIQUES RECHERCHES (Int.Cl.7) |
| Y | US 6 055 173 A (HABERSETZER DARYL L ET AL) 25 avril 2000 (2000-04-25) | 5-7, 13-15 | G11C |
| A | * colonne 3, ligne 20 - colonne 6, ligne 16; figures 2-6 * | 1,3,4, 10,11,13 | |
| Y | US 5 497 475 A (ALAPAT VARKEY P) 5 mars 1996 (1996-03-05) * abrégé; figures 1-3 * | 9,18 | |

Le présent rapport a été établi pour toutes les revendications

| Lieu de la recherche | Date d'achèvement de la recherche | Examinateur |
|---|---|---|
| LA HAYE | 29 août 2003 | Cummings, A |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**
EP 03 00 7639

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-08-2003

| Document brevet cité au rapport de recherche | | Date de publication | Membre(s) de la famille de brevet(s) | | Date de publication |
|---|---|---|---|---|---|
| US 2002136076 | A1 | 26-09-2002 | WO | 02078001 A2 | 03-10-2002 |
| | | | WO | 02078003 A2 | 03-10-2002 |
| | | | US | 2003021148 A1 | 30-01-2003 |
| | | | US | 2003022420 A1 | 30-01-2003 |
| | | | US | 2003027378 A1 | 06-02-2003 |
| | | | US | 2003026120 A1 | 06-02-2003 |
| | | | US | 2003031067 A1 | 13-02-2003 |
| | | | US | 2002136059 A1 | 26-09-2002 |
| | | | US | 2002136045 A1 | 26-09-2002 |
| | | | US | 6522594 B1 | 18-02-2003 |
| | | | US | 2003053332 A1 | 20-03-2003 |
| | | | US | 2002136047 A1 | 26-09-2002 |
| | | | US | 6504753 B1 | 07-01-2003 |
| | | | US | 6545898 B1 | 08-04-2003 |
| WO 02078003 | A | 03-10-2002 | US | 2002136047 A1 | 26-09-2002 |
| | | | WO | 02078001 A2 | 03-10-2002 |
| | | | WO | 02078003 A2 | 03-10-2002 |
| | | | US | 2003021148 A1 | 30-01-2003 |
| | | | US | 2003022420 A1 | 30-01-2003 |
| | | | US | 2003027378 A1 | 06-02-2003 |
| | | | US | 2003026120 A1 | 06-02-2003 |
| | | | US | 2003031067 A1 | 13-02-2003 |
| | | | US | 2002136059 A1 | 26-09-2002 |
| | | | US | 2002136045 A1 | 26-09-2002 |
| | | | US | 2002136076 A1 | 26-09-2002 |
| | | | US | 6522594 B1 | 18-02-2003 |
| | | | US | 2003053332 A1 | 20-03-2003 |
| | | | US | 6504753 B1 | 07-01-2003 |
| | | | US | 6545898 B1 | 08-04-2003 |
| US 6229733 | B1 | 08-05-2001 | US | 6435584 B1 | 20-08-2002 |
| US 5684732 | A | 04-11-1997 | JP | 3361006 B2 | 07-01-2003 |
| | | | JP | 8330944 A | 13-12-1996 |
| US 6055173 | A | 25-04-2000 | US | 5689455 A | 18-11-1997 |
| | | | US | 2002167831 A1 | 14-11-2002 |
| | | | US | 2002163827 A1 | 07-11-2002 |
| | | | US | 6130834 A | 10-10-2000 |
| | | | US | 6445605 B1 | 03-09-2002 |
| US 5497475 | A | 05-03-1996 | DE | 69411890 D1 | 27-08-1998 |
| | | | EP | 0682803 A1 | 22-11-1995 |
| | | | JP | 8506683 T | 16-07-1996 |
| | | | WO | 9418676 A2 | 18-08-1994 |

EPO FORM P0460

Pour tout renseignement concernant cette annexe : voir Journal Officiel de l'Office européen des brevets, No.12/82